# FASCICULE DE BREVET EUROPEEN

(11) **EP 0 983 712 B1**
(45) Date de publication et mention de la délivrance du brevet: **05.09.2001**
(21) Numéro de dépôt: 98925755.5
(22) Date de dépôt: 20.05.1998
(51) Int. Cl.: H05K 1/18, H05K 5/00, H01R 12/16

(54) **PLAQUE ELECTRONIQUE PLIEE A 45 DEGRES**
UNTER 45 GRAD GEBOGENE ELEKTRONISCHE PLATTE
ELECTRONIC PLATE FOLDED AT 45 DEGREES

(30) Priorité: 23.05.1997 FR 9706311
(43) Date de publication de la demande: 08.03.2000
(73) Titulaire: MAGNETI MARELLI FRANCE, 92000 Nanterre (FR)
(72) Inventeur: DUFOUR, Jacques, F-86100 Saint-Sauveur (FR)
(74) Mandataire: Bérogin, Francis
(86) Numéro de dépôt international: FR9801009
(87) Numéro de publication internationale: WO9853652

(56) Documents cités:
- GB-A- 1 136 753
- PATENT ABSTRACTS OF JAPAN vol. 15, no. 295 (E-1094), 26 juillet 1991 & JP 03 104296 A (MAZDA MOTOR CORP.), 1 mai 1991
- "Riser card with additional circuit function" IBM TECHNICAL DISCLOSURE BULLETIN., vol. 34, no. 5, octobre 1991, page 15 XP000189640 NEW YORK US

## Description

La présente invention est relative à une plaque électronique comprenant d'une part, une face de travail destinée à porter un circuit électronique ainsi que des composants électroniques montés en surface et reliés les uns aux autres par ledit circuit, une face de protection opposée à ladite face de travail et d'autre part, une extrémité destinée à être rabattue en direction de la face de travail et supportant, sur la face de protection, un connecteur à broches traversantes, ce connecteur possédant une face de liaison à un circuit électrique et une face de connexion audit circuit électronique et qui est en contact avec la face de travail.

La présente invention est également relative au procédé de fabrication d'une plaque électronique.

De telles plaques électroniques couramment rencontrées dans l'état de la technique utilisent des connecteurs dont les broches sont droites ou cambrées à 90°. Ces connecteurs utilisés sont des connecteurs à broches traversantes et sont soudés sur des plaques électroniques composées d'un substrat qui peut être soit rigide, lorsqu'il est réalisé en un matériau composite du type FR4 bien connu de l'homme du métier, soit souple lorsqu'il est réalisé en un matériau composite du type Flex également connu de l'homme du métier. Ces connecteurs sont soudés par le procédé appelé "soudure à la vague".

Lorsque les plaques électroniques possèdent des composants électroniques seulement sur une seule face, une évolution récente de ces composants a conduit à utiliser un procédé de brasage appelé "brasage par refusion", pour souder ces composants sur la plaque.

Aussi, afin de minimiser le nombre des étapes de fabrication de la plaque électronique, il a été développé des connecteurs appelés connecteurs montés en surface dont les broches ne sont plus traversantes mais sont montées en surface, sur la surface de la plaque électronique destinée à porter les composants électroniques.

Toutefois, cette technique de fabrication est limitée par le nombre de broches des connecteurs montés en surface. En effet, il est très difficile d'obtenir l'appui d'un très grand nombre de broches dans un même plan lorsque ces broches sont cambrées à 90°. Ceci est particulièrement vrai lorsque le nombre de broches du connecteur dépasse 50.

Par conséquent, lorsque le nombre de broches est trop important, il existe seulement deux solutions pour souder les composants électroniques et le connecteur sur la plaque électronique.

Une première solution consiste à utiliser à la fois le brasage par refusion et la soudure à la vague. Ce procédé est coûteux dans la mesure où deux techniques de soudage sont employées et qu'il est nécessaire de s'assurer que toutes les broches sont bien soudées.

Une deuxième solution consiste à utiliser une plaque électronique dont le substrat est un substrat type Flex se présentant sous la forme d'une plaque plane et sur lequel sont soudés par refusion les composants électroniques et le connecteur. Il faut ensuite plier à 90° le substrat Flex pour que la face de liaison du connecteur à un circuit électrique extérieur soit perpendiculaire à la surface générale de la plaque électronique. Cette orientation du connecteur est une exigence impérative formulée par les utilisateurs. Toutefois, cette deuxième solution est également d'un coût onéreux dans la mesure où le procédé de fabrication du substrat Flex est d'un prix de revient élevé.

Patent Abstracts of Japan, vol 15, no. 295 (E 1094), 26.07.91 concerne une plaque électronique selon le préambule de la revendication 1.

La présente invention a pour but de remédier aux inconvénients mentionnés ci-dessus à savoir, obtenir un coût de fabrication d'une plaque électronique faible, en utilisant uniquement le procédé de brasage par refusion tout en s'assurant que la face de liaison du connecteur est perpendiculaire à la surface générale de la plaque électronique.

A cet effet, l'invention a pour objet une plaque électronique comprenant :
- une face de travail destinée à porter un circuit électronique ainsi que des composants électroniques montés en surface et reliés les uns aux autres par ledit circuit,
- une face de protection opposée à ladite face de travail, et
- une extrémité destinée à être rabattue en direction de la face de travail et portant, sur la face de protection, un connecteur à broches traversantes, ce connecteur possédant une face de liaison à un circuit électrique et une face de connexion audit circuit électronique et qui est en contact avec la face de travail,
essentiellement caractérisée en ce que :
la plaque est réalisée en un matériau pliable selon un angle α ne pouvant être supérieur à sensiblement 50°, la face de connexion du connecteur formant avec la face de liaison un angle complémentaire dudit angle de pliage α, de sorte que la face de liaison et la face de protection soient sensiblement perpendiculaires.

La plaque électronique suivant l'invention peut éventuellement comporter en outre, une ou plusieurs des caractéristiques suivantes :
- les broches traversantes du connecteur sont coudées de manière à être sensiblement perpendiculaires à la face de connexion de ce connecteur ;
- l'angle de pliage α est d'environ 45° ;
- la plaque électronique est réalisée en un matériau du type FR4 ;
- la plaque électronique est réalisée en un matériau du type CEM ;
- la plaque électronique possède une épaisseur inférieure à 0,6 mm environ.

La présente invention a également pour objet un boîtier électronique dont l'une des faces est constituée par la plaque électronique possédant l'une quelconque des caractéristiques mentionnées ci-dessus et dans lequel le connecteur est accessible sur l'une des faces.

La présente invention a en outre pour objet un procédé de fabrication d'une plaque électronique possédant l'une quelconque des caractéristiques mentionnées ci-dessus, ce procédé comprenant les étapes consistant à souder par refusion les composants électroniques ainsi que le connecteur et à plier l'extrémité de la plaque électronique.

Un exemple de réalisation de l'invention va maintenant être décrit en regard des dessins annexés, sur lesquels :
- la figure 1 est une vue en coupe longitudinale d'une plaque électronique selon la présente invention et comportant des composants montés en surface ainsi qu'un connecteur à broches traversantes ;
- la figure 2 est une vue analogue à celle de la figure 1, l'extrémité de la plaque électronique portant le connecteur ayant été pliée ; et
- la figure 3 est une vue en perspective de la plaque électronique des figures 1 et 2, destinée à former l'une des faces d'un boîtier électronique.

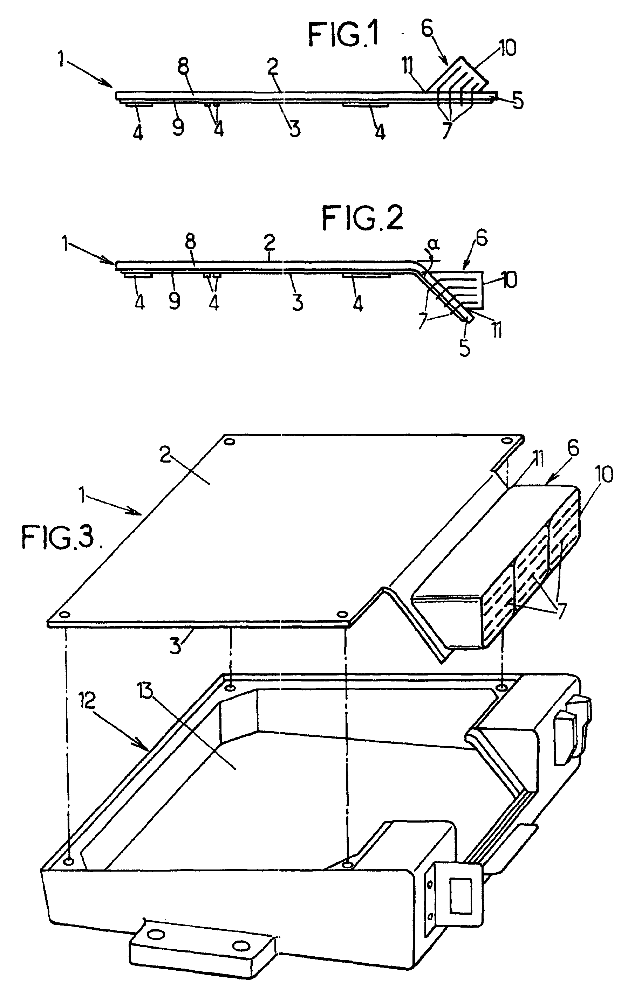

La plaque électronique 1 représentée à la figure 1 possède, de manière connue en soi, une face de travail 3 et une face de protection 2 opposée à ladite face 3. La face de travail 3 porte des composants électroniques 4 reliés les uns aux autres par un circuit électronique (non représenté). Ces composants électroniques sont appelés composants montés en surface (CMS).

La plaque électronique 1 possède en outre une extrémité 5 sur laquelle est fixé un connecteur 6 selon la présente invention à broches traversantes 7.

Par ailleurs, la plaque électronique 1 est constituée d'un drain thermique 8 réalisé, par exemple, en aluminium ainsi que d'un substrat mince réalisé, par exemple, en un matériau composite du type FR4 ou du type CEM bien connu de l'homme du métier.

Le drain thermique 8 est placé du côté de la face de protection de la plaque 1 tandis que le substrat mince 9 est placé du côté de la face de travail 3 de la plaque. Ce substrat est utilisé à des épaisseurs comprises entre 0,2 et 0,6 mm, ce qui le rend semi-rigide pour pouvoir tolérer des pliages selon un angle α pouvant atteindre 45 à 50°. On entend également par pliable, le fait que le matériau utilisé peut être plié tout en présentant un très faible rayon de courbure par rapport aux dimensions générales de la plaque électronique.

Par ailleurs, le connecteur 6 à broches traversantes 7 possède une face 10 de liaison à un circuit électrique extérieur ainsi qu'une face 11 de connexion au circuit électronique porté par le substrat 9.

Selon la présente invention, la face de connexion 10 du connecteur 6 forme avec la face de liaison 11 un angle complémentaire de l'angle de pliage α de sorte que, après pliage de l'extrémité 5 de la plaque électronique 1 selon l'angle α, la face de liaison 10 du connecteur 6 soit sensiblement perpendiculaire au reste de la surface de la plaque électronique.

De plus, les extrémités des broches 7 faisant saillie du côté de la face de connexion 11 sont recourbées pour être perpendiculaires à la plaque électronique.

Le procédé de fabrication de la plaque électronique 1 selon la présente invention, consiste à placer le connecteur 6 à l'extrémité 5 de la plaque électronique 1, la face de connexion 11 étant en contact avec la face de protection 2 de la plaque 1, ainsi qu'à placer les composants électroniques 4 du côté de la face de travail 3 de ladite plaque.

Le procédé consiste ensuite à souder l'ensemble des composants et du connecteur par refusion.

La dernière étape du procédé consiste ensuite à plier l'extrémité 5 de la plaque 1 selon l'angle α compris entre 45 et 50°, de sorte que la face de liaison 10 du connecteur 6 soit perpendiculaire à la surface générale de la plaque 1.

Enfin, à la figure 3, est représenté un boîtier électronique 12 dont la face supérieure 13 est constituée par la plaque électronique 1 précédemment décrite. On comprend ainsi que le connecteur 6, immobilisé sur la plaque électronique 1 selon le procédé économique de la présente invention, possède une face de liaison 10 parallèle à l'une des faces latérales du boîtier 12 et est accessible de l'extérieur.

## Revendications

1. Plaque électronique comprenant :
- une face de travail (3) destinée à porter un circuit électronique ainsi que des composants électroniques (4) montés en surface et: reliés les uns aux autres par ledit circuit,
- une face de protection (2) opposée à ladite face de travail (3), et
- une extrémité (5) destinée à être rabattue en direction de la face de travail (3) et portant, sur la face de protection (2), un connecteur (6) à broches traversantes (7), ce connecteur (6) possédant une face (10) de liaison à un circuit électrique et une face (11) de connexion audit circuit électronique et qui est en contact avec la face de travail (3),
**caractérisée en ce que** la plaque (1) est réalisée en un matériau pliable selon un angle α ne pouvant être supérieur à sensiblement 50°, la face de connexion (11) du connecteur (6) formant avec la face de liaison (10) un angle complémentaire dudit angle de pliage α, de sorte que la face de liaison (10) et la face de protection (2) soient sensiblement perpendiculaires.

2. Plaque électronique selon la revendication 1, **caractérisée en ce que** les broches traversantes (7) du connecteur (6) sont coudées de manière à être sensiblement perpendiculaires à la face de connexion (11) de ce connecteur (6).

3. Plaque électronique selon la revendication 2, **caractérisée en ce que** l'angle de pliage α est d'environ 45°.

4. Plaque électronique selon la revendication 3, **caractérisée en ce qu**'elle est réalisée en un matériau du type FR4.

5. Plaque électronique selon la revendication 3, **caractérisée en ce qu**'elle est réalisée en un matériau du type CEM.

6. Plaque électronique selon la revendication 4 ou 5, **caractérisée en ce qu**'elle possède une épaisseur inférieure à 0,6 mm environ.

7. Boîtier électronique **caractérisé en ce que** l'une des faces (13) est constituée par la plaque électronique (1) selon l'une quelconque des revendications 1 à 6 et en ce que le connecteur (6) est accessible sur l'une des faces.

8. Procédé de fabrication d'une plaque électronique selon l'une quelconque des revendications 1 à 6, **caractérisé en ce qu**'il comprend les étapes consistant à :
- souder par refusion les composants électroniques (4) ainsi que le connecteur (6) ; et
- plier l'extrémité (5) de la plaque électronique (1).

## Claims

1. Electronic plate comprising :
- a work face (3) intended to support an electronic circuit as well as electronic components (4) mounted on the surface and connected together through the said circuit,
- a protection face (2) opposite the said work face (3) and
- an end (5) intended to be folded in the direction of the work face (3) and supporting on the protection face (2) a connector (6) with traversing pins (7), this connector (6) having a face (10) for connection with an electric circuit and a face (11) connecting with the said electronic circuit and which is in contact with the work face (3),
**characterised in that** the plate (1) is made of a pliable material bending according to an angle α which cannot be more than substantially 50°, the connection face (11) of the connector (6) forming with the connecting face (10) a complementary angle with the said bending angle α, so that the connecting face (10) and the protection face (2) are substantially perpendicular.

2. Electronic plate according to claim 1 **characterised in that** the traversing pins (7) of the connector (6) are angled so as to be substantially perpendicular to the connection face (11) of this connector (6).

3. Electronic plate according to claim 2 **characterised in that** the bending angle α is about 45°.

4. Electronic plate according to claim 3 **characterised in that**
it is made of a material of the type FR4.

5. Electronic plate according to claim 3 **characterised in that** it is made of a material of the type CEM.

6. Electronic plate according to claim 4 or 5 **characterised in that** it has a thickness less than about 0.6 mm.

7. Electronic box **characterised in that** one of the faces (13) is comprised of the electronic plate (1) according to any of claims 1 to 6 and in that the connector (6) is accessible on one of its faces.

8. Method of manufacturing an electronic plate according to any of claims 1 to 6 **characterised in that** it comprises the stages consisting in:
- soldering by re-fusing the electronic components (4) as well as the connector (6); and
- folding the end (5) of the electronic plate (1).

## Patentansprüche

1. Elektronische Platte, enthaltend
- eine Arbeitsseite (3), die einen elektronischen Stromkreis trägt sowie elektronische Bauteile (4), die auf der Oberfläche befestigt und durch den Stromkreis miteinander verbunden sind,
- eine der Arbeitsseite (3) gegenüberliegende Schutzseite (2),
- ein Ende (5), das in Richtung der Arbeitsseite (3) umgebogen ist und auf der Schutzseite (2) eine Steckverbindung (6) mit querliegenden Kontaktstiften (7), wobei die Steckverbindung (6) eine mit einem elektrischen Stromkreis verbundene Fläche (10) und eine mit dem elektrischen Stromkreis in Verbindung stehende Fläche (11) aufweist und mit der Arbeitsseite (3) in Berührung kommt,
**dadurch gekennzeichnet**, daß die Platte (1) aus einem Material besteht, das um einen Winkel gebogen werden kann, der nicht großer als etwa 50° ist, wobei die Verbindungsfläche (11) der Steckverbindung (6) mit der Verbindungsfläche (10) einen Winkel bildet, der den Biegewinkel α ergänzt, so daß die Verbindungsfläche (10) und die Schutzseite (2) im wesentlichen senkrecht sind.

2. Elektronische Platte nach Anspruch 1, **dadurch gekennzeichnet**, daß die querliegenden Kontaktstifte (7) der Steckverbindung (6) so gebogen sind, daß sie im wesentlichen senkrecht zur Verbindungsfläche (11) der Steckverbindung (6) liegen.

3. Elektronische Platte nach Anspruch 2, **dadurch gekennzeichnet**, daß der Biegewinkel α etwa 45° beträgt.

4. Elektronische Platte nach Anspruch 3, **dadurch gekennzeichnet**, daß sie aus einem Material des Typs FR4 hergestellt ist.

5. Elektronische Platte nach Anspruch 3, **dadurch gekennzeichnet**, daß sie aus einem Material des Typs CEM hergestellt ist.

6. Elektronische Platte nach Anspruch 4 oder 5, **dadurch gekennzeichnet**, daß sie eine geringere Stärke von etwa 0,6 mm aufweist.

7. Elektronisches Gehäuse, **dadurch gekennzeichnet**, daß eine der Flächen (13) aus einer elektronischen Platte (1) gemäß einem der Ansprüche 1 bis 6 besteht und daß die Steckverbindung (6) auf einer der Flächen angeordnet ist.

8. Verfahren zur Herstellung einer elektronischen Platte nach einem der Ansprüche 1 bis 6, **dadurch gekennzeichnet**, daß es folgende Verfahrensschritte aufweist:
- Löten der elektronischen Bauteile (4) sowie der Steckverbindung (6); und
- Biegen des Endes (5) der elektronischen Platte (1).
